# EUROPEAN PATENT APPLICATION

(11) **EP 4 528 815 A1**
(43) Date of publication of application: **26.03.2025**
(21) Application number: 24194239.0
(22) Date of filing: 13.08.2024
(51) Int. Cl.: H01L 25/065

(54) **INTEGRATED CIRCUIT PACKAGES WITH DOUBLE HYBRID BONDED DIES AND METHODS OF MANUFACTURING THE SAME**

(30) Priority: 22.09.2023 US 202318473046
(71) Applicant: Intel Corporation, Santa Clara, CA 95054 (US)
(72) Inventor: KARHADE, Omkar, Chandler, 85248 (US); DESHPANDE, Nitin Ashok, Chandler, 85286 (US); ANTARTIS, Dimitrios, Hillsboro, 97123 (US); KIM, Gwang-Soo, Portland, 97229 (US); LIFF, Shawna Marie, Scottsdale, 85255 (US)
(74) Representative: Goddar, Heinz J.

(57) **Abstract**

Systems, apparatus, and articles of manufacture are disclosed to enable integrated circuit packages with double hybrid bonded dies and methods of manufacturing the same include an integrated circuit (IC) package including a first semiconductor die including first metal vias spaced apart along a first layer of a first dielectric material, the first metal vias connected to respective first metal pads of the first semiconductor die, a second semiconductor die including second metal pads of the second semiconductor die, and a hybrid bond layer including a third dielectric material and third metal vias spaced apart along the third dielectric material, a subset of the third metal vias electrically coupling ones of the first metal pads to respective ones of the second metal pads, a first one of the third metal vias positioned beyond a lateral side of the first semiconductor die.

## Description

### FIELD OF THE DISCLOSURE

This disclosure relates generally to electronic devices and, more particularly, to double hybrid bonded dies and methods of manufacturing the same.

### BACKGROUND

The rapid speed of data transmission within computation, storage and communication infrastructures is pushing the speed boundary of traditional copper-based electrical links. Additionally, with the increasing functionality of circuitry and increasing density of semiconductor devices, physically positioning a sufficient number of interconnects on an exterior surface of a die has become increasingly difficult. Die stacking allows for multi-chip package structures that enable significant performance leaps in computing capability and memory/processor integration. The multi-chip package structures, made possible by die stacking, allow for increased speed in data transmission, because die stacking allows for more interconnects on the exterior surface of the die.

### BRIEF DESCRIPTION OF THE DRAWINGS

FIG. 1 illustrates an example integrated circuit (IC) package that is electrically coupled to a circuit board.
FIG. 2A illustrates an example semiconductor package.
FIG. 2B illustrates an example first portion of the example semiconductor package of FIG. 2A.
FIG. 2C illustrates the example pads of the example semiconductor package of FIG. 2A.
FIG. 3 illustrates the example semiconductor package of FIG. 2A on a wafer.
FIG. 4 illustrates the example semiconductor package of FIG. 2A on a package substrate.
FIGS. 5-11 illustrate various stages in an example process of fabrication of the example semiconductor package of FIG. 2A.
FIG. 12 is a flowchart representative of an example method of manufacturing the example semiconductor package of FIG. 2A in accordance with example techniques described in connection with FIGS. 5-11.
FIG. 13 is a top view of a wafer and dies that may be included in an IC package constructed in accordance with teachings disclosed herein.
FIG. 14 is a cross-sectional side view of an IC device that may be included in an IC package constructed in accordance with teachings disclosed herein.
FIG. 15 is a cross-sectional side view of an IC device assembly that may include an IC package constructed in accordance with teachings disclosed herein.
FIG. 16 is a block diagram of an example electrical device that may include an IC package constructed in accordance with teachings disclosed herein.

In general, the same reference numbers are used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real-world applications. For example, "approximately" and "about" may modify dimensions that may not be exact due to manufacturing tolerances and/or other real-world imperfections as will be understood by persons of ordinary skill in the art. For example, "approximately" and "about" may indicate such dimensions may be within a tolerance range of +/- 50% unless otherwise specified in the below description.

As used herein "substantially real time" refers to occurrence in a near instantaneous manner recognizing there may be real world delays for computing time, transmission, etc. Thus, unless otherwise specified, "substantially real time" refers to real time + 1 second.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example an integrated circuit may be implemented as one or more of an ASIC, an FPGA, a chip, a microchip, programmable circuitry, a semiconductor substrate coupling multiple circuit elements, a system on chip (SoC), etc.

### DETAILED DESCRIPTION

Hybrid bonding is a process that requires at least two surfaces that are both flat and clean (e.g., a first flat and clean surface to be hybrid bonded to a second flat and clean surface). Hybrid bonding has been used to connect various combinations of wafers, chips, and dies. In some examples, the hybrid bonding is performed to connect a first wafer and a second wafer. According to a hybrid bonding process, after chemical-mechanical planarization (e.g., CMP) of the first and second wafers, the first wafer and the second wafer may be bonded directly. After the bonding, the wafer-to-wafer hybrid bonded package undergoes a die singulation, testing, and handling that increases a surface contamination, which can result in low yields. In some examples, the hybrid bonding is performed to connect a first wafer and a chip. In such examples, there are higher yields for a chip-to-wafer hybrid bonded package due to die disaggregation.

A hybrid bond connects a first metal surface and a second metal surface. In some examples, the hybrid bonding process is to connect the two clean surfaces through a hydrogen bond. In some examples, a chip-to-chip configuration is used. However, in such examples, dirt (e.g., residue) can build up on the die before and after singulation of the first die. The example residue on the first die reduces the connection between the dies. The reduced connection reduces the efficiency of a computing device by limiting the surface area that is available for hybrid bond.

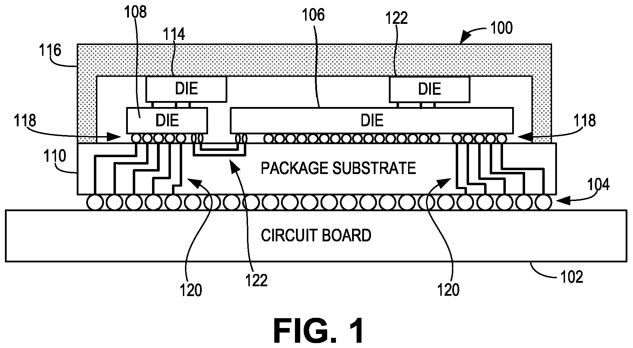

FIG. 1 illustrates an example integrated circuit (IC) package 100 that is electrically coupled to a circuit board 102. In some examples, the IC package 100 is electrically coupled to the circuit board 102 by first electrical connections 104. The first electrical connections 104 may include pins, pads, bumps, and/or balls to enable the electrical coupling of the IC package 100 to the circuit board 102. The first electrical connections 104 between the IC package 100 and the circuit board 102 are sometimes referred to as second level interconnects.

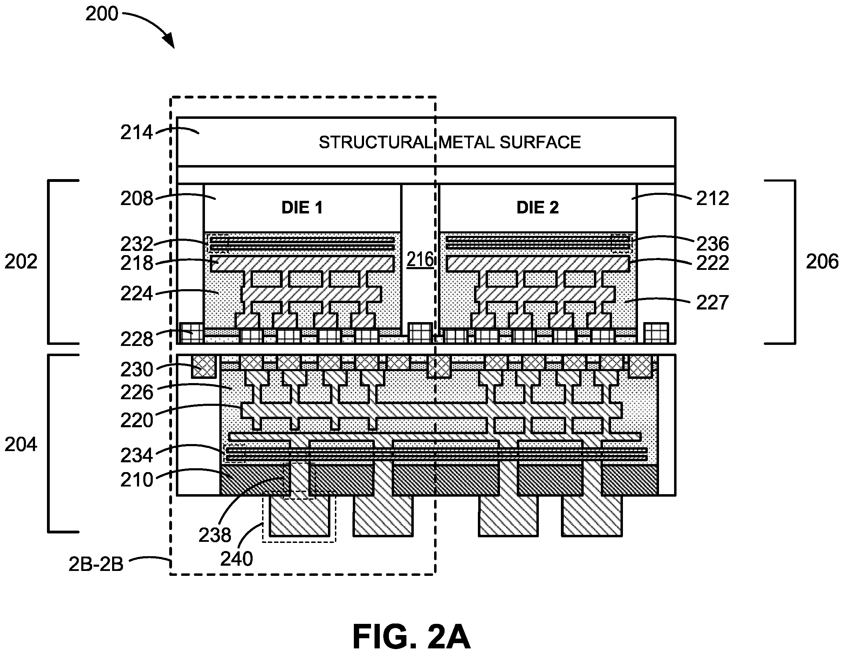

In this example, the IC package 100 includes two semiconductor dies 106, 108 (e.g., two silicon dies) that are mounted to a package substrate 110. The IC package 100 includes a third semiconductor die 112 that is bonded (e.g., adjacent, attached, connected) above the first semiconductor die 106 and a fourth semiconductor die 114 that is bonded (e.g., adjacent, attached, connected) above the second semiconductor die 108. The four dies 106, 108, 112, 114 are enclosed by a package lid or mold compound 116. While the example IC package 100 of FIG. 1 includes four dies 106, 108, 112, 114 in other examples, the IC package 100 may have only one die or more than four dies. FIG. 1 is a generic package that illustrates dies that can be stacked (e.g., hybrid bonded). An example implementation of die stacking of FIG. 1 is illustrated in FIGS. 2A - 2C.

As shown in the example of FIG. 1, the dies 106, 108 are electrically and mechanically coupled to the package substrate 110 via second electrical connections 118. The second electrical connections 118 may include pins, pads, balls, and/or bumps. The second electrical connections 118 between the dies 106, 108 and the package substrate 110 are sometimes referred to as first level interconnects. In some examples, one or both of the dies 106, 108 may be stacked on top of one or more other dies and/or an interposer such as the third die 112. In such examples, the dies 106, 108 are coupled to the underlying die and/or interposer through a first set of first level interconnects and the underlying die and/or interposer may be connected to the package substrate 110 via a separate set of first level interconnects associated with the underlying die and/or interposer.

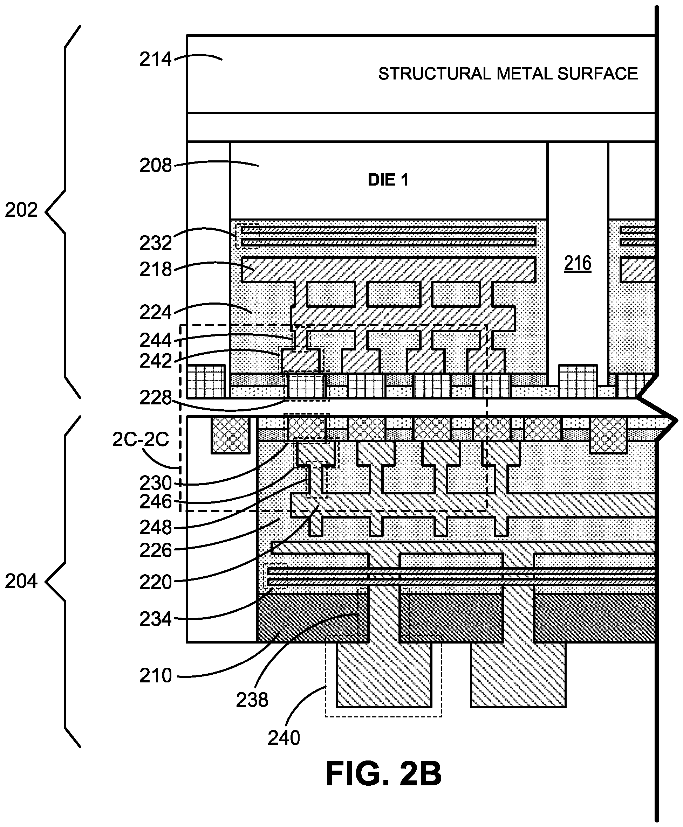

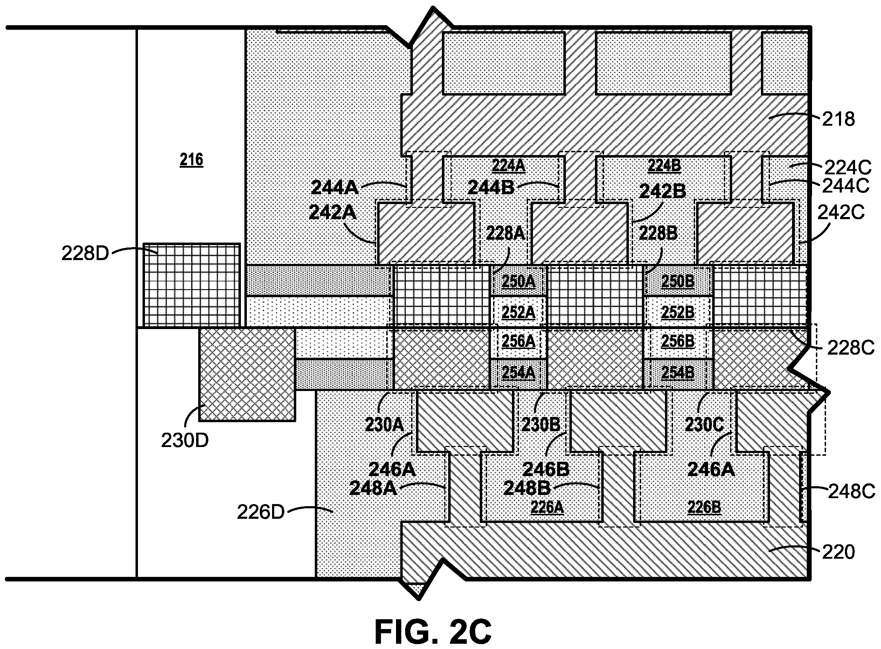

As shown in the illustrated example, the package substrate 110 includes first electrical traces and/or routing 120 that electrically connects the first electrical connections 104 with the second electrical connections 118, thereby enabling the electrical coupling of the first and/or second dies 106, 108 with the circuit board 102. Further, in some examples, the package substrate 110 includes second electrical traces and/or routing 122 that electrically connect different ones of the first electrical connections 104 associated with the first and second dies 106, 108, thereby enabling the electrical coupling of the first and second dies 106, 108. FIG. 1 is an illustration of a generic semiconductor package showing the second die 108 and the fourth die 114 being stacked. An example stacking of the dies that could be implemented in FIG. 1 is illustrated in FIG. 2.

As used herein, a "known good die" is a die that has been tested. The testing process of the dies occurs by using a testing pad which is a region of the die to is adjacent to an electrical source. These known good dies are singulated (e.g., chopped, cut into smaller wafers), and after singulation into wafers, the wafers are reconstituted to form a reconstituted die. The reconstituted die is then tested again to determine if the die is ready for use in an electrical circuit (e.g., the IC package 100 of FIG. 1). The example third die 112 and the example first die 106 may be connected through a hybrid bonding process. In some examples, the fourth die 114 and the example second die 108 are connected through a hybrid bonding process.

FIG. 2A is an illustration of an example semiconductor package 200 including an example first die 202, an example second die 204, and an example third die 206. The example first die 202 includes an example first bulk semiconductor region 208, the example second die 204 includes an example second bulk semiconductor region 210, and the example third die includes an example third bulk semiconductor region 212.

The example first die 202 and the example third die 206 are connected by an example structural metal surface 214 (e.g., a lid, a base, a carrier, an example silicon lid, a structural silicon, a structural silicon surface). The example structural metal surface 214 may function as a lid or a base (e.g., carrier) based on the orientation of the semiconductor package. There is an example first dielectric fill 216 (e.g., oxide fill) deposited between the first die 202 and the third die 206.

The example first die 202 includes an example first metal interconnects 218. The example first metal interconnects 218 includes first metal vias 244 (labeled in FIGS. 2B-2C) and first metal pads 242 (labeled in FIGS. 2B-2C). In some examples, the first metal pads 242 (labeled in FIGS. 2B - 2C) are also referred to as "first conductive pads." In some examples, the first metal pads 242 (labeled in FIGS. 2B - 2C) are also referred to as "hybrid bond pads." In some examples, the first metal pads 242 (labeled in FIGS. 2B - 2C) are formed from copper. The example second die 204 includes example second metal interconnects 220 and the example third die 206 includes example third metal interconnects 222. The example second metal interconnects 220 include second metal vias 248 (labeled in FIGS. 2B-2C) and second metal pads 246 (labeled in FIGS. 2B - 2C) (e.g., second conductive pads, hybrid bond pads). The example first die 202 includes an example second dielectric fill 224. In some examples, the second dielectric fill 224 is composed of the same dielectric material (e.g., oxide) as the first dielectric fill 216. The example second die 204 includes an example third dielectric fill 226 and the example third die 206 includes an example fourth dielectric fill 227.

The example first die 202 and the example third die 206 include example third metal pads 228 (e.g., third conductive metal pads, third metal vias, first pad-sized metal vias, first hybrid bond pads). The example second die 204 includes example fourth metal pads 230 (e.g., fourth conductive metal pads, fourth metal vias, second pad-sized metal vias, second hybrid bond pads). The example third metal pads 228 are in contact with respective ones of the example first metal pads 242 (labeled in FIGS. 2B-2C) of the first metal interconnects 218 and the example fourth metal pads 230. The example third metal pads 228 may have a lateral size that is similar (e.g., within -50% to +400%, larger, smaller etc.) to the lateral size of the first metal pads 242 (labeled in FIGS. 2B - 2C). In some examples, the third metal pads 228 have a lateral size that is substantially different than the first metal pads 242 (e.g., as small as half the size of the first metal pads 242 (labeled in FIGS. 2B - 2C) and as large as four times the size of the first metal pads 242 (labeled in FIGS. 2B - 2C). In some examples, the third metal pads 228 may have a lateral size that is approximately (e.g., within 10%) equal to the lateral size of the first metal pads 242 (labeled in FIGS. 2B - 2C).

The example fourth metal pads 230 are in contact with the example second metal pads (labeled in FIGS. 2B-2C) of the second metal interconnects 220 and the example third metal pads 228. The contact of the fourth metal pads 230 and the third metal pads 228 allows the first metal interconnects 218 and the second metal interconnects 220 to be electrically connected. Without the third metal pads 228 and the fourth metal pads 230, the surface area of the first metal interconnects 218 that contacts the second metal interconnects 220 would be decreased. The example third metal pads 228 are aligned with the example fourth metal pads 230 but are still in significant contact with the first metal pads (labeled in FIGS. 2B-2C). In this example, the third metal pads 228 are at least approximately sixty percent aligned (e.g., misaligned by up to forty percent) with the fourth metal pads 230 and at least approximately ninety percent aligned (e.g., misaligned by up to ten percent) with the first metal pads 242 (FIGS. 2B - 2C). That is, in some examples, the misalignment of the third metal pads 228 and the first metal pads 242 is less than the misalignment of the third metal pads 228 and the fourth metal pads 230. In other examples, the percentage of alignment may be different based on the size of the pads (e.g., the third metal pads 228, the first metal pads 242 (FIGS. 2B - 2C), the fourth metal pads 230, etc.), the pitch between the pads, and the maximum current requirements. In other examples, the third metal pads 228 are at least approximately ninety percent aligned (e.g., misaligned by up to ten percent) with the fourth metal pads 230 and at least approximately sixty percent aligned (e.g., misaligned by up to forty percent) with the first metal pads 242 (FIGS. 2B - 2C). That is, in some examples, the misalignment of the third metal pads 228 and the first metal pads 242 is greater than the misalignment of the third metal pads 228 and the fourth metal pads 230. This design increases the efficiency of a computing device, as the increased surface area allows for faster transmission of electrical signals. As shown in the example of FIG. 2A, one of the third metal pads 228 is disposed in the example first dielectric fill 216. A subset of the third metal pads 228 (e.g., third metal vias and first pad-sized metal vias, etc.) electrically couple ones of the first metal pads 242 (FIGS. 2B - 2C). The first pad-sized metal vias (e.g., the third metal pads 228) are electrically coupling ones of the first metal pads 242 (FIGS. 2B - 2C).

In some examples, the example first die 202 and the example third die 206 can be considered one long die that is in contact with the example second die 204. The first die 202 and the third die 206 are opposite from (e.g., facing towards) the second die 204. The first die 202 is positioned laterally adjacent to the example third die 206. However, the first die 202 may be formed from a first process and the third die 206 may be formed from a second process. The example first die 202 and the example third die 206 do not need to be from the same initial die substrate. In such examples, the spacing (e.g., pitch) between the first metal pads 242 (labeled in FIGS. 2B-2C) of the first die 202 may be a first spacing value and the spacing (e.g., pitch) between the first metal pads 242 (labeled in FIGS. 2B-2C) of the third die 206 may be a second spacing value that is different from the first spacing value. Therefore, the fourth metal pads 230 may be misaligned by a first extent to the first metal pads 242 (labeled in FIGS. 2B - 2C) of the first die 202 and may be misaligned by a second extend to the first metal pads 242 (labeled in FIGS. 2B - 2C) of the third die 206. However, the pitch (e.g., spacing) of the third metal pads 228 is consistent across both the first die 202 and the third die 206.

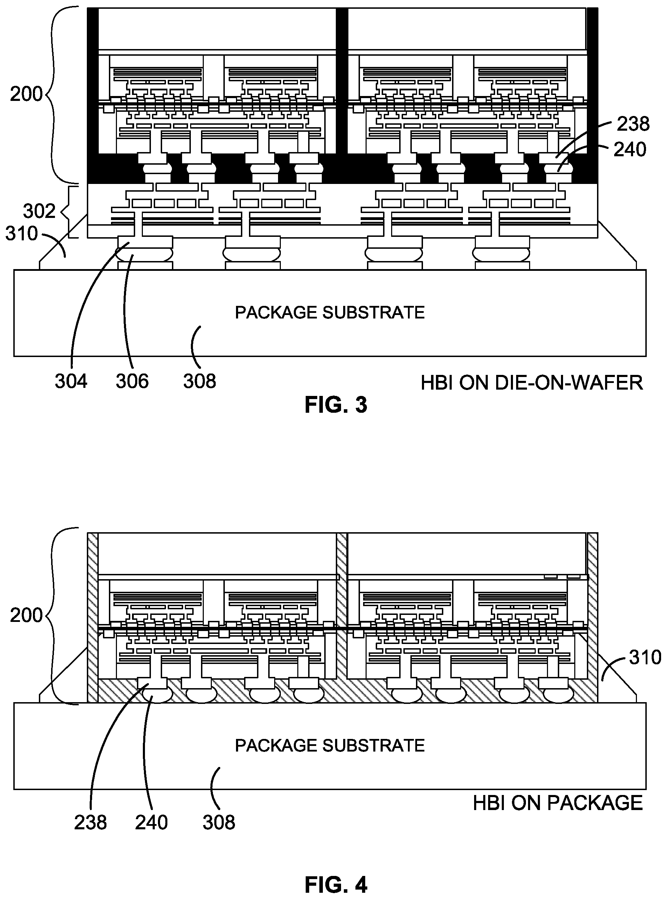

The example first die 202 includes example first transistors 232, the example second die 204 includes example second transistors 234, and the example third die 206 includes example third transistors 236. The example second die 204 includes an example through-silicon-vias 238 and example bumps 240. As described in connection with FIGS. 3-4, the example bumps 240 of the semiconductor package 200 can be used to attach the semiconductor package 200 to either a wafer (FIG. 3) or a package substrate (FIG. 4).

FIG. 2B illustrates an example first portion of the example semiconductor package 200 of FIG. 2A. The example first portion of the example semiconductor package 200 includes the same reference numbers as the example of FIG. 2A. FIG. 2B further illustrates the example first metal pads 242 that extend from first metal vias 244 of the first metal interconnects 218. The example first metal pads 242 are in contact with the example third metal pads 228. In the example of FIGS. 2B, ones of the example third metal pads 228 are deposited inside ones of the first metal pads 242. In some examples, the first metal pads 242 are referred to as a first hybrid bond pad layer and the third metal pads 228 are referred to as a second hybrid bond pad layer. The combination of the first hybrid bond pad layer and the second hybrid bond pad layer (labeled in FIGS. 2B - 2C) may be referred to as a first hybrid bond pad layer and a second bond pad layer which forms a double hybrid bond pad layer as there are two separate hybrid bonds.

Though the example of FIG. 2B illustrates an example space between the example third metal pads 228 and the example fourth metal pads 230, in some examples the third metal pads 228 are in contact with the example fourth metal pads 230. In some examples, the third metal pads 228 are in contact with the example second metal pads 246. In such examples, the second metal pads 246 are exposed for electrical connection and there are no fourth metal pads 230. The example second metal pads 246 are shown extending from the example second metal interconnects 220 of the second die 204.

FIG. 2C illustrates the example pads of the semiconductor package 200 in contact. In the example of FIG. 2C, the various metal pads are labeled with letters to indicate first, second, third, etc. However, in other examples, any number of metal pads may be used.

The example first metal vias 244 include an example first metal via 244A, an example second metal via 244B, and an example third metal via 244C. These first metal vias 244 are connected to respective first metal pads 242 (e.g., an example first metal pad 242A, an example second metal pad 242B, and an example third metal pad 242C). An example second dielectric fill 224 (e.g., the first dielectric fill 216 of FIGS. 2A - 2C has not been deposited yet) is deposited between the first metal vias 244 and the example first metal pads 242 (e.g., a first portion of the second dielectric fill 224A is between the combination of the example first metal via 244A and the example first metal pad 242A and the example second metal via 244B and the example second metal pad 242B. In some examples, the second dielectric fill 224 is composed of the same dielectric (e.g., Silicon Oxide, Silicon Nitride) as the first dielectric fill 216.

The example first portion of the second dielectric fill 224A and the example second metal via 244B are in contact with an example first portion of an example sacrificial via layer 250A. The example sacrificial via layer 250 is in contact with an example third dielectric layer 252 (e.g., Silicon Oxide, Silicon Nitride, Silicon Carbon Nitride). The example first portion of the example sacrificial via layer 250A is in contact with an example first portion of the example third dielectric layer 252A. Similarly, the example second portion of the example sacrificial via layer 250B is in contact with the example second portion of the example third dielectric layer 252B. In some examples, the third dielectric layer 252 is the same material as the example second dielectric fill 224 disposed between the first metal pads 242. In some examples, the third dielectric layer 252 is the same material as the example first dielectric fill 216. In some examples, the sacrificial via layer 250 is formed as a dielectric such as Silicon-Oxide (SiO) or Silicon-Nitride (SiN). However, as most of the sacrificial via layer 250 is removed at a later point, a variety of dielectrics may be used.

The example second die 204 includes an example first portion of the example fourth dielectric layer 256A which in contact with the example first portion of the example third dielectric layer 252A. The example first portion of the fourth dielectric layer 256A is in contact with the example first portion of a second sacrificial via layer 254A. Similarly, an example second portion of the fourth dielectric layer 256B is in contact with an example second portion of the third dielectric layer 252B and an example second portion of the second sacrificial via layer 254B. The example second die 204 includes fourth metal pads 230 (e.g., a first metal pad 230A, a second metal pad 230B, a third metal pad 230C) which are in contact with the example second metal vias 230 (e.g., a first one of the second metal vias 230A, a second one of the second metal vias 230B, and a third one of the second metal vias 230C). Similarly, the example second die 204 includes portions of the example third dielectric fill 226 that have been deposited in between the second metal vias 248.

As shown in the example of FIG. 2C, respective ones of the example third metal pads 228 are in contact with respective ones of the example first metal pads 242. In some examples, the first metal pads 242 are formed with the example first metal vias 244. In such examples, the first metal pads 242 are referred to as second metal vias or pad-sized metal vias. The first metal pads 242 are in electrical connection with the example second metal pads 246 of the example second die 204, through the example third metal pads 228 and the example fourth metal pads 230. As shown in the example of FIG. 2C, the first metal pads 242 are mostly aligned with the example third metal pads 228. The percentage of alignment or overlap of the first metal pads 242 and the third metal pads 228 is at least sixty percent or higher (e.g., at least 75%, at least 90%). However, the example third metal pads 228 are significantly more aligned with the example fourth metal pads 230 compared to the alignment of the first metal pads 242 and the third metal pads 228. The percentage of alignment or overlap of the third metal pads 228 and the fourth metal pads 230 is at least sixty percent or higher (e.g., at least 75%, at least 90%). The example second metal pads 246 are barely aligned with the example first metal pads 242. However, the third metal pads 228 and the fourth metal pads 230 correct for the offset (e.g., reduce the effects of the offset) between the third metal pads 228 and the fourth metal pads 230. The example first metal pads 242 are misaligned with respective ones of the third metal pads 228.

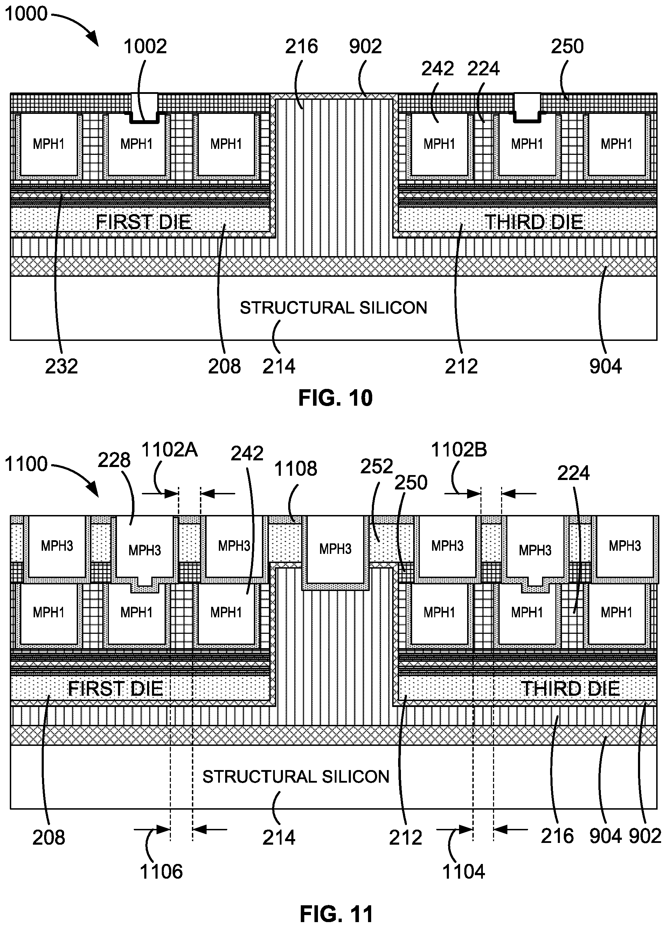

The example fourth one of the third metal pads 228D is offset deeper into the example second dielectric fill 224. The first one of the third metal pads 228A is stopped by the example first one of the first metal pads 242A, and therefore does not lie as deep into the example second dielectric fill 224. The example fourth one of the third metal pads 228D is beyond a lateral side of the first metal interconnects 218. The example fourth one of the third metal pads 228D extends away from the example second dielectric fill 224 by a greater distance than the other example ones of the third metal pads 228A, 228B, and 228C. The example fourth one of the third metal pads 228D is electrically isolated from the other metal within the second dielectric fill 224. This is due to the manufacturing process that distributes the third metal pads 228 with a consistent pitch across the surface of the first die 202 and the surface of the third die 206. In some examples, ones of the third metal pads 228 are indented (e.g., have a metal indentation) that is disposed within ones of the first metal pads 242 (e.g., as shown in connection with connection with FIG. 11).

FIG. 3 illustrates how the example semiconductor package 200 is attached to an example wafer 302. The example wafer 302 includes example through-silicon-vias 304 and an example bumps 306 which are used to attach the example wafer 302 to the example package substrate 308. The example semiconductor package 200 is hybrid-bonded to the example wafer 302. The example through-silicon-vias 238 and the example bumps 240 of the semiconductor package 200 are used to attach the semiconductor package 200 to the example wafer 302. The example underfill 310 is to fill in gaps between the package substrate 308 (e.g., printed circuit board) and the example wafer 302.

FIG. 4 illustrates the example semiconductor package 200 on a package substrate 308. The example semiconductor is hybrid-bonded directly onto the example package substrate 308. The example through-silicon-vias 238 and the example bumps 240 of the semiconductor package 200 are attached to the example package substrate 308. The example underfill 310 is to fill in gaps between the package substrate 308 (e.g., printed circuit board) and the example semiconductor package 200.

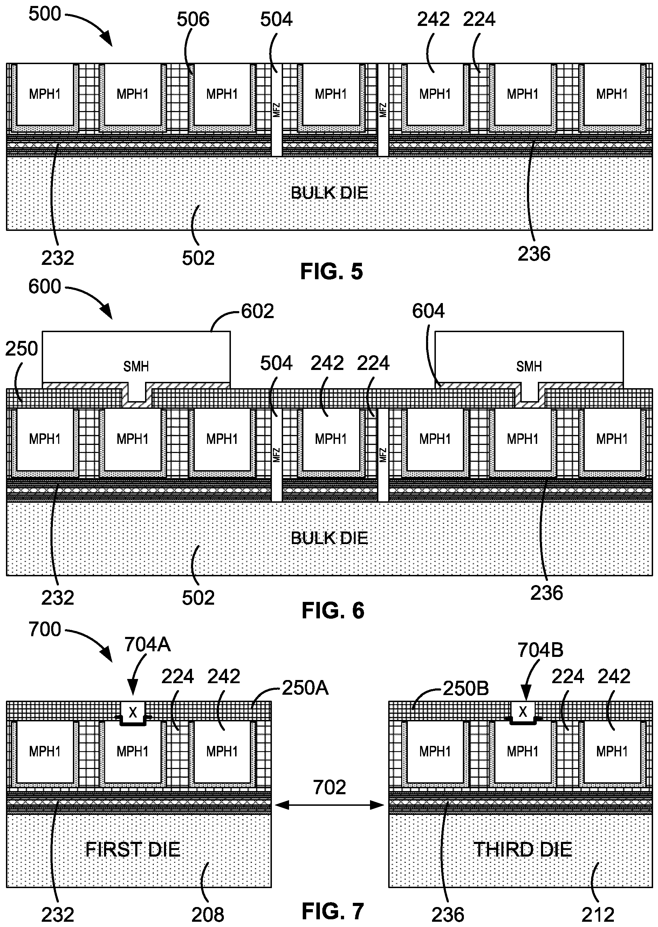

FIG. 5 illustrates a first stage 500 for generating the semiconductor package 200 of FIGS. 2A-2C. The example first stage 500 includes a bulk die 502 that is attached to the example first transistors 232 and the example third transistors 236. The example of FIG. 5 simplifies the semiconductor package by omitting the first metal vias 244 and some of the structure of the first metal interconnects 218. In the simplification of FIG. 5, the example first metal pads 242 are attached to the example first transistors 232 (because some of the structure of the first metal interconnects 218 has been omitted). The example first metal pads 242 include a first liner layer 506. The example bulk die 502 includes example metal-free zones 504. The example metal-free zones 504 divide portions of the second dielectric fill 224. In some examples, the metal-free zones 504 are not drawn to scale.

FIG. 6 illustrates a second stage 600. The example second stage 600 includes the addition of an example sacrificial via layer 250. The example sacrificial via layer 250 is deposited on top of the example first metal pads 242 and the portions of the second dielectric fill 224. After the deposition of the example sacrificial via layer 250, example testing pads 602 are placed in contact with ones of the example first metal pads 242. The example testing pads 602 are used to confirm that the dies are functioning accurately. The example testing pads 602 include a sacrificial testing layer 604. In some examples, a first one of the testing pads 602 is larger than a respective first one of the first metal pads 242 that underlies the first one of the testing pads 602. The example testing pads 602 are underlying the example first metal pads 242.

FIG. 7 illustrates an example third stage 700. After testing the portions of first metal pads 242 of the bulk die 502, the testing pads 602 and the sacrificial testing layer 604 are removed. The removal of the testing pads 602 generates alignment marks 704 (e.g., a first alignment mark 704A and a second alignment mark 704B). By removing the testing pads 602, the example third stage 700 exposes the sacrificial via layer 250. The alignment marks 704 are indentations or openings where in connection with the example seventh stage 1100, metal is added to the openings to define the third metal pads 228. After the removal of the testing pads 602, the bulk die 502 is singulated (e.g., chopped, cut, separated) at the locations of the example metal-free zones 504. A first singulated and tested portion of example bulk die 502 is now referred to as the example first bulk semiconductor region 208 of FIGS. 2A-2B, and another singulated and tested portion of the example bulk die 502 is referred to as the example third bulk semiconductor region 212 of FIG. 2A. In the example of FIG. 2A, the third bulk semiconductor region 212 is in the horizontal plane of the first bulk semiconductor region 208, while the example second bulk semiconductor region 210 is in the vertical plane of the first bulk semiconductor region 208. In the example of FIGS. 5 - 11, the first bulk semiconductor region 208 and the third bulk semiconductor region 212 are in focus. Even though only two dies will appear in FIGS. 5 - 11, the reference numeral and label of "third bulk semiconductor region 212" and "third die 206" will be used for consistency between FIGS. 5-11 and FIG. 2A.

In some examples, the third bulk semiconductor region 212 is the portion that was physically next to the first bulk semiconductor region 208 before singulation. In some examples, the testing process revealed that the portion that was physically next to the first bulk semiconductor region 208 is defective, and the example third bulk semiconductor region 212 is a portion that was not physically next to the first bulk semiconductor region 208 before singulation. The example first bulk semiconductor region 208 and the example third bulk semiconductor region 212 are placed apart by a first distance 702.

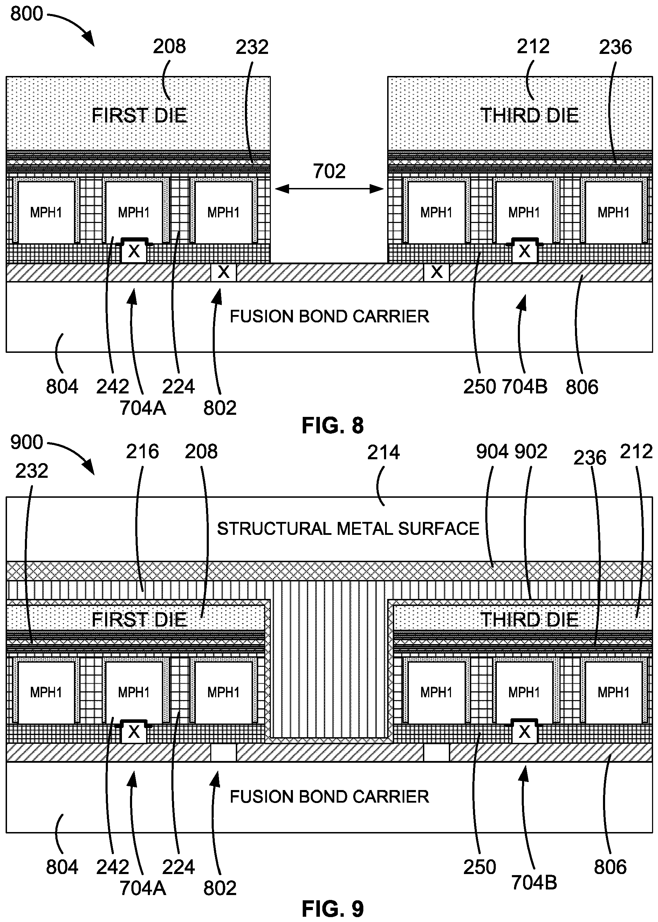

FIG. 8 illustrates an example fourth stage 800. The example first bulk semiconductor region 208 and the example third bulk semiconductor region 212 are attached to an example fusion bond carrier 804 that includes a fusion layer 806. The example fusion layer 806 includes second alignment spaces 1002. The first bulk semiconductor region 208 and the third bulk semiconductor region 212 are spaced apart by the example first distance 702 when fused to the example fusion bond carrier 804. Before FIG. 9, the example first bulk semiconductor region 208 and the example third bulk semiconductor region 212 are polished down to around a thickness often microns. For example, a chemical-mechanical-planarization (CMP) process may be used to remove some of the excess semiconductor material.

FIG. 9 illustrates an example fifth stage 900. At the example fifth stage 900, a first liner layer 902 is deposited over the first bulk semiconductor region 208, the spaced marked by the first distance 702 and the third bulk semiconductor region 212. After the deposition of the first liner layer 902, the example first dielectric fill 216 is deposited over the first liner layer 902. In some examples, the first liner layer 902 may be formed from an alloy including silicon and nitrogen (SiN), or from an alloy including silicon, carbon, and nitrogen (SiCN). However, in some situations the liner material cannot be formed from an alloy including Silicon and Oxygen (SiO). Then an example structural metal surface 214 is attached (e.g., a metal lid, a silicon lid, a silicon base, a metal base). The example structural metal surface 214 includes an example second liner layer 904.

FIG. 10 illustrates an example sixth stage 1000. At the example sixth stage 1000, the example fusion bond carrier 804 and the example fusion layer 806 are removed, which exposes the example sacrificial via layer 250. The removal of the fusion bond carrier 804 and the fusion layer 806 exposes example alignment spaces 1002. The example alignment spaces 1002 are not horizontal with the first metal pads 242.

FIG. 11 illustrates an example seventh stage 1100. At the example seventh stage 1100, the example third metal pads 228 are deposited onto the first metal pads 242. The example second metal pads 246 of FIG. 2C are associated with the example second die 204 and are not shown, as the second die 204 is in the vertical plane of the first die 202. Some of the metal that forms the third metal pads 228 fills the alignment spaces 1002 (e.g., the indentations in ones of the first metal pads 242, the openings in ones of the first metal pads 242 etc.). One of the third metal pads 228 is deposited in the example first dielectric fill 216 (e.g., oxide fill). The example one of the third metal pads 228 that is deposited in the example first dielectric fill 216 is not horizontal with the other third metal pads 228 due to the other third metal pads 228 being in contact with the surfaces of the first metal pads 242. A third dielectric layer 252 is deposited in between ones of the third metal pads 228. The example third dielectric layer 252 may be the same material as the first dielectric fill 216 and/or the second dielectric fill 224. The third metal pads 228 are planarized and an etch stop layer 1108 is applied.

In the example of FIG. 11, an example first width 1102 is shown between some of the third metal pads 228 that are associated with the first bulk semiconductor region 208 (e.g., width 1102A) and the example first width 1102 is shown between some of the third metal pads 228 that are associated with the example third bulk semiconductor region 212 (e.g., width 1102B). The example width 1102A is the example same as the example width 1102B. The example second width 1104, which is associated with the example third bulk semiconductor region 212 may be a different amount of space than the example first width 1102. The example third width 1106 which is associated with the example first bulk semiconductor region 208 may be a different amount of space than the example first width 1102 and the second width 1104. The example first die 202 may be attached to an example second die 204 (not shown in FIG. 11) where the third metal pads 228 are in contact with fourth metal pads 230 (not shown in FIG. 11).

In the example of FIG. 11, a horizontal plane that defines the first hybrid bond layer includes the third metal pads 228 and the portions of the dielectric.

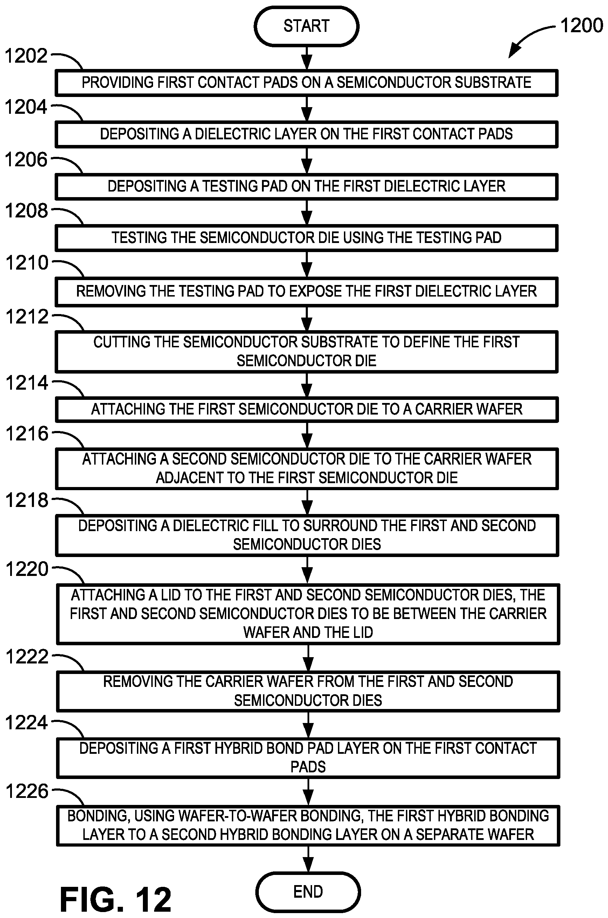

FIG. 12 is a flowchart illustrating an example method of manufacturing a semiconductor package (e.g., the semiconductor package 200 of FIGS. 2A-2C) as described above in connection with FIGS. 5 - 11. In some examples, the example method of FIG. 12 is a method of manufacturing integrated circuit packages. Although the example method of manufacture is described with reference to the flowchart illustrated in FIG. 12, many other methods may alternatively be used. For example, the order of execution of the blocks may be changed, and/or some of the blocks described may be combined, divided, re-arranged, omitted, eliminated, and/or implemented in any other way. The example process will use the reference numbers associated with FIGS. 2A-2C, with some reference numbers introduced between FIGS. 5-11.

The example process 1200 begins at block 1202 by providing first contact pads on a semiconductor substrate. Using the terms and reference numerals from FIG. 5, the first contact pads are the first metal pads 242 which are placed on a bulk die 502. The semiconductor substrate may be formed out of silicon. The first contact pads may be formed out of copper. However, other materials may be used.

At block 1204, the example process 1200 deposits a dielectric layer on the first contact pads. Using the terms and reference numerals from FIG. 6, a sacrificial via layer 250 is deposited on the first metal pads 242. Portions of the sacrificial via layer 250 will be removed (e.g., sacrificed).

At block 1206, the example process 1200 deposits a testing pad on the first dielectric layer. Using the terms and reference numerals from FIG. 6, a testing pad 602 is deposited on the example sacrificial via layer 250.

At block 1208, the example process 1200 tests the semiconductor die using the testing pad. Using the terms and reference numerals from FIG. 6, the testing pad 602 is used to confirm an electrical connection status of the first metal pads 242 that make up the bulk die 502.

At block 1210, the example process 1200 removes the testing pad to expose the first dielectric layer (e.g., the sacrificial via layer). Using the terms and reference numerals from FIG. 7, the testing pad 602 is removed to expose the example sacrificial via layer 250.

At block 1212, the example process 1200 cuts the semiconductor substrate to define the first semiconductor die. Using the terms and reference numerals from FIG. 7, the bulk die 502 is cut into multiple portions such as an example first die 202 that is defined by the example first bulk semiconductor region 208, the first transistors 232, portions of the second dielectric fill 224, and some of the first metal pads 242, and some of the sacrificial via layer 250. The flowchart of FIG. 12 will use the term "second die" for the example third bulk semiconductor region 212, the example third transistors 236, some of the first metal pads 242, portions of the second dielectric fill 224, and some of the sacrificial via layer 250 because the first die 202 and the third die 206 are the ordinal first die and the ordinal second die that are attached adjacent to one another.

At block 1214, the example process 1200 attaches the first semiconductor die to a carrier wafer. Using the terms and reference numerals from FIG. 8, the first die 202 is attached to an example fusion bond carrier 804.

At block 1216, the example process 1200 attaches a second semiconductor die to the carrier wafer adjacent to the first semiconductor die. Using the terms and reference numerals from FIG. 8, the second die that is attached to the carrier wafer 802 is the example third die 206 of FIG. 2A.

At block 1218, the example process 1200 deposits a dielectric fill to surround the first and second semiconductor dies. Using the terms and reference numerals from FIG. 9, the dielectric fill is the example first dielectric fill 216. In other examples, the dielectric fill may be oxide.

At block 1220, the example process 1200 attaches a lid to the first and second semiconductor dies, where the first semiconductor die and the second semiconductor die are between the carrier wafer and the lid. Using the terms and reference numerals from FIG. 9, the lid is a structural metal surface 214 that may be considered either a lid (e.g., top) or a base (e.g., bottom, carrier) depending on the orientation of the semiconductor package 200. The structural metal surface 214 may be formed from silicon or other similar metals.

At block 1222, the example process 1200 removes the carrier wafer from the first semiconductor die and the second semiconductor die. Using the terms and reference numerals from FIG. 10, the fusion bond carrier 804 is removed from the first die 202 and the third die 206. The example semiconductor package is rotated, so that the structural metal surface 214 is acting as a carrier wafer before the start of block 1224.

At block 1224, the example process 1200 deposits a first hybrid bond pad layer on the first contact pads. Using the terms and reference numerals from FIG. 11, the example process 1200 deposits the example third metal pads 228 onto the example first metal pads 242. In some examples, the first hybrid bond pad layer includes the third metal pads 228. In other examples, the first hybrid bond pad layer includes the third metal pads 228 and the third dielectric layer 252 that is positioned in-between ones of the third metal pads 228.

At block 1226, the example process 1200 bonds, by using wafer-to-wafer bonding, the first hybrid bonding layer to a second hybrid bonding layer on a separate wafer. Using the terms and reference numerals from FIG. 2A, the first hybrid bonding layer is the set of third metal pads 228 of both the first die 202 and the third die 206 that are, through wafer-to-wafer bonding, bonded to the fourth metal pads 230 of the second die 204, where the fourth metal pads 230 is the second hybrid bonding layer.

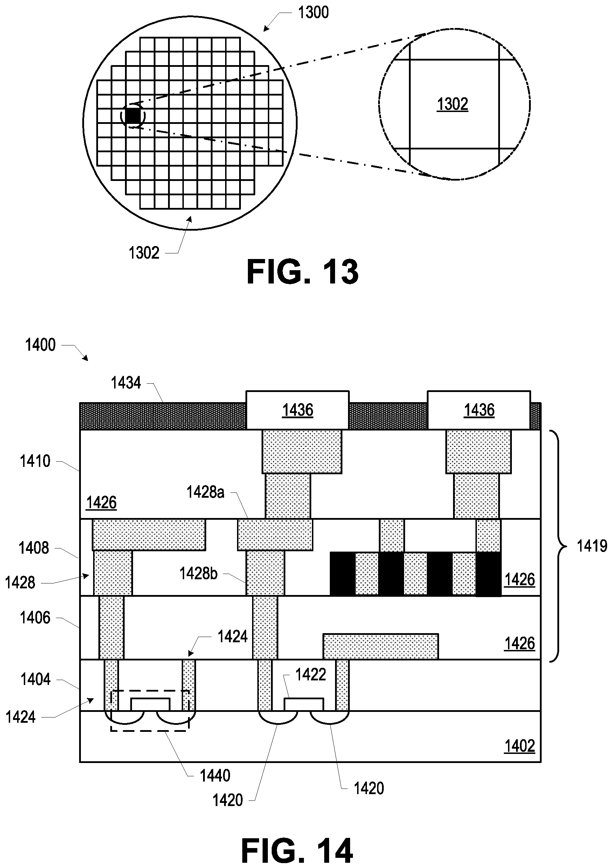

FIG. 13 is a top view of a wafer 1300 and dies 1302 that may be included in the IC package 100 of FIG. 1 (e.g., as any suitable ones of the dies) in accordance with teachings disclosed herein. The wafer 1300 may be composed of semiconductor material and may include one or more dies 1302 having IC structures formed on a surface of the wafer 1300. Each of the dies 1302 may be a repeating unit of a semiconductor product that includes any suitable IC. After the fabrication of the semiconductor product is complete, the wafer 1300 may undergo a singulation process in which the dies 1302 are separated from one another to provide discrete "chips" of the semiconductor product. The die 1302 may include one or more transistors (e.g., some of the transistors 1440 of FIG. 14, discussed below), supporting circuitry to route electrical signals to the transistors, passive components (e.g., signal traces, resistors, capacitors, or inductors), and/or as well as any other IC components. In some examples, the wafer 1300 or the die 1302 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1302. For example, a memory array formed by multiple memory devices may be formed on a same die 1302 as a processing device (e.g., the processing device 1400 of FIG. 14) or other logic that is configured to store information in the memory devices or execute instructions stored in the memory array. The example IC package 100 disclosed herein may be manufactured using a die-to-wafer assembly technique in which some dies are attached to a wafer 1300 that include others of the dies, and the wafer 1300 is subsequently singulated.

FIG. 14 is a cross-sectional side view of an IC device 1400 that may be included in the example IC package 100 (e.g., in any one of the dies) constructed in accordance with teachings disclosed herein. One or more of the IC devices 1400 may be included in one or more dies 1302 (FIG. 13). The IC device 1400 may be formed on a substrate 1402 (e.g., the wafer 1300 of FIG. 13) and may be included in a die (e.g., the die 1302 of FIG. 13). The substrate 1402 may be a semiconductor substrate composed of semiconductor material systems including, for example, n-type or p-type materials systems (or a combination of both). The substrate 1402 may include, for example, a crystalline substrate formed using a bulk silicon or a silicon-on-insulator (SOI) substructure. In some examples, the substrate 1402 may be formed using alternative materials, which may or may not be combined with silicon, which include but are not limited to germanium, indium antimonide, lead telluride, indium arsenide, indium phosphide, gallium arsenide, or gallium antimonide. Further materials classified as group II-VI, III-V, or IV may also be used to form the substrate 1402. Although a few examples of materials from which the substrate 1402 may be formed are described here, any material that may serve as a foundation for an IC device 1400 may be used. The substrate 1402 may be part of a singulated die (e.g., the dies 1302 of FIG. 13) or a wafer (e.g., the wafer 1300 of FIG. 13).

The IC device 1400 may include one or more device layers 1404 disposed on the substrate 1402. The device layer 1404 may include features of one or more transistors 1440 (e.g., metal oxide semiconductor field-effect transistors (MOSFETs)) formed on the substrate 1402. The device layer 1404 may include, for example, one or more source and/or drain (S/D) regions 1420, a gate 1422 to control current flow in the transistors 1440 between the S/D regions 1420, and one or more S/D contacts 1424 to route electrical signals to/from the S/D regions 1420. The transistors 1440 may include additional features not depicted for the sake of clarity, such as device isolation regions, gate contacts, and the like. The transistors 1440 are not limited to the type and configuration depicted in FIG. 14 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 1440 may include a gate 1422 formed of at least two layers, a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some examples, an annealing process may be carried out on the gate dielectric to improve its quality when a high-k material is used.

The gate electrode may be formed on the gate dielectric and may include at least one p-type work function metal or n-type work function metal, depending on whether the transistor 1440 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer. For a PMOS transistor, metals that may be used for the gate electrode include, but are not limited to, ruthenium, palladium, platinum, cobalt, nickel, and conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide), and any of the metals discussed above with reference to a PMOS transistor (e.g., for work function tuning).

In some examples, when viewed as a cross-section of the transistor 1440 along the source-channel-drain direction, the gate electrode may consist of a U-shaped structure that includes a bottom portion substantially parallel to the surface of the substrate and two sidewall portions that are substantially perpendicular to the top surface of the substrate. In other examples, at least one of the metal layers that form the gate electrode may simply be a planar layer that is substantially parallel to the top surface of the substrate and does not include sidewall portions substantially perpendicular to the top surface of the substrate. In other examples, the gate electrode may consist of a combination of U-shaped structures and planar, non-U-shaped structures. For example, the gate electrode may consist of one or more U-shaped metal layers formed atop one or more planar, non-U-shaped layers.

In some examples, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some examples, a plurality of spacer pairs may be used; for instance, two pairs, three pairs, or four pairs of sidewall spacers may be formed on opposing sides of the gate stack.

The S/D regions 1420 may be formed within the substrate 1402 adjacent to the gate 1422 of each transistor 1440. The S/D regions 1420 may be formed using an implantation/diffusion process or an etching/deposition process, for example. In the former process, dopants such as boron, aluminum, antimony, phosphorous, or arsenic may be ion-implanted into the substrate 1402 to form the S/D regions 1420. An annealing process that activates the dopants and causes them to diffuse farther into the substrate 1402 may follow the ion-implantation process. In the latter process, the substrate 1402 may first be etched to form recesses at the locations of the S/D regions 1420. An epitaxial deposition process may then be carried out to fill the recesses with material that is used to fabricate the S/D regions 1420. In some implementations, the S/D regions 1420 may be fabricated using a silicon alloy such as silicon germanium or silicon carbide. In some examples, the epitaxially deposited silicon alloy may be doped in situ with dopants such as boron, arsenic, or phosphorous. In some examples, the S/D regions 1420 may be formed using one or more alternate semiconductor materials such as germanium or a group III-V material or alloy. In further examples, one or more layers of metal and/or metal alloys may be used to form the S/D regions 1420.

Electrical signals, such as power and/or input/output (I/O) signals, may be routed to and/or from the devices (e.g., transistors 1440) of the device layer 1404 through one or more interconnect layers disposed on the device layer 1404 (illustrated in FIG. 14 as interconnect layers 1406-1410). For example, electrically conductive features of the device layer 1404 (e.g., the gate 1422 and the S/D contacts 1424) may be electrically coupled with the interconnect structures 1428 of the interconnect layers 1406-1410. The one or more interconnect layers 1406-1410 may form a metallization stack (also referred to as an "ILD stack") 1419 of the IC device 1400.

The interconnect structures 1428 may be arranged within the interconnect layers 1406-1410 to route electrical signals according to a wide variety of designs (in particular, the arrangement is not limited to the particular configuration of interconnect structures 1428 depicted in FIG. 14). Although a particular number of interconnect layers 1406-1410 is depicted in FIG. 14, examples of the present disclosure include IC devices having more or fewer interconnect layers than depicted.

In some examples, the interconnect structures 1428 may include lines 1428a and/or vias 1428b filled with an electrically conductive material such as a metal. The lines 1428a may be arranged to route electrical signals in a direction of a plane that is substantially parallel with a surface of the substrate 1402 upon which the device layer 1404 is formed. For example, the lines 1428a may route electrical signals in a direction in and out of the page from the perspective of FIG. 14. The vias 1428b may be arranged to route electrical signals in a direction of a plane that is substantially perpendicular to the surface of the substrate 1402 upon which the device layer 1404 is formed. In some examples, the vias 1428b may electrically couple lines 1428a of different interconnect layers 1406-1410 together.

The interconnect layers 1406-1410 may include a dielectric material 1426 disposed between the interconnect structures 1428, as shown in FIG. 14. In some examples, the dielectric material 1426 disposed between the interconnect structures 1428 in different ones of the interconnect layers 1406-1410 may have different compositions; in other examples, the composition of the dielectric material 1426 between different interconnect layers 1406-1410 may be the same.

A first interconnect layer 1406 (referred to as Metal 1 or "M1 ") may be formed directly on the device layer 1404. In some examples, the first interconnect layer 1406 may include lines 1428a and/or vias 1428b, as shown. The lines 1428a of the first interconnect layer 1406 may be coupled with contacts (e.g., the S/D contacts 1424) of the device layer 1404.

A second interconnect layer 1408 (referred to as Metal 2 or "M2") may be formed directly on the first interconnect layer 1406. In some examples, the second interconnect layer 1408 may include vias 1428b to couple the lines 1428a of the second interconnect layer 1408 with the lines 1428a of the first interconnect layer 1406. Although the lines 1428a and the vias 1428b are structurally delineated with a line within each interconnect layer (e.g., within the second interconnect layer 1408) for the sake of clarity, the lines 1428a and the vias 1428b may be structurally and/or materially contiguous (e.g., simultaneously filled during a dual-damascene process) in some examples.

A third interconnect layer 1410 (referred to as Metal 3 or "M3 ") (and additional interconnect layers, as desired) may be formed in succession on the second interconnect layer 1408 according to similar techniques and configurations described in connection with the second interconnect layer 1408 or the first interconnect layer 1406. In some examples, the interconnect layers that are "higher up" in the metallization stack 1419 in the IC device 1400 (i.e., further away from the device layer 1404) may be thicker.

The IC device 1400 may include a solder resist material 1434 (e.g., polyimide or similar material) and one or more conductive contacts 1436 formed on the interconnect layers 1406-1410. In FIG. 14, the conductive contacts 1436 are illustrated as taking the form of bond pads. The conductive contacts 1436 may be electrically coupled with the interconnect structures 1428 and configured to route the electrical signals of the transistor(s) 1440 to other external devices. For example, solder bonds may be formed on the one or more conductive contacts 1436 to mechanically and/or electrically couple a chip including the IC device 1400 with another component (e.g., a circuit board). The IC device 1400 may include additional or alternate structures to route the electrical signals from the interconnect layers 1406-1410; for example, the conductive contacts 1436 may include other analogous features (e.g., posts) that route the electrical signals to external components.

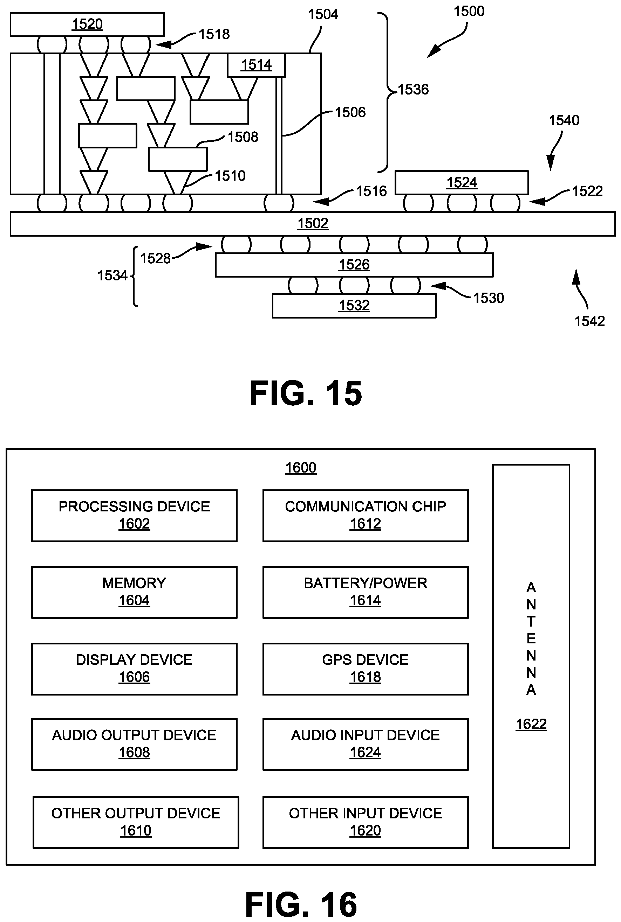

FIG. 15 is a cross-sectional side view of an IC device assembly 1500 that may include the IC package 100 with any one of the example package substrates disclosed herein constructed in accordance with teachings disclosed herein. The IC device assembly 1500 includes a number of components disposed on a circuit board 1502 (which may be, for example, a motherboard). The IC device assembly 1500 includes components disposed on a first face 1540 of the circuit board 1502 and an opposing second face 1542 of the circuit board 1502; generally, components may be disposed on one or both faces 1540 and 1542. Any of the IC packages discussed below with reference to the IC device assembly 1500 may take the form of any of the examples of the IC package 100 of FIG. 1.

In some examples, the circuit board 1502 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1502. In other examples, the circuit board 1502 may be a non-PCB substrate. In some examples, the circuit board 1502 may be, for example, the circuit board of FIG. 1.

The IC device assembly 1500 illustrated in FIG. 15 includes a package-on-interposer structure 1536 coupled to the first face 1540 of the circuit board 1502 by coupling components 1516. The coupling components 1516 may electrically and mechanically couple the package-on-interposer structure 1536 to the circuit board 1502 and may include solder balls (as shown in FIG. 15), male and female portions of a socket, an adhesive, an underfill material, and/or any other suitable electrical and/or mechanical coupling structure.

The package-on-interposer structure 1536 may include an IC package 1520 coupled to an interposer 1504 by coupling components 1518. The coupling components 1518 may take any suitable form for the application, such as the forms discussed above with reference to the coupling components 1516. Although a single IC package 1520 is shown in FIG. 15, multiple IC packages may be coupled to the interposer 1504; indeed, additional interposers may be coupled to the interposer 1504. The interposer 1504 may provide an intervening substrate used to bridge the circuit board 1502 and the IC package 1520. The IC package 1520 may be or include, for example, a die (the die 1302 of FIG. 13), an IC device (e.g., the IC device 1400 of FIG. 14), or any other suitable component. Generally, the interposer 1504 may spread a connection to a wider pitch or reroute a connection to a different connection. For example, the interposer 1504 may couple the IC package 1520 (e.g., a die) to a set of BGA conductive contacts of the coupling components 1516 for coupling to the circuit board 1502. In the example illustrated in FIG. 15, the IC package 1520 and the circuit board 1502 are attached to opposing sides of the interposer 1504; in other examples, the IC package 1520 and the circuit board 1502 may be attached to a same side of the interposer 1504. In some examples, three or more components may be interconnected by way of the interposer 1504.

The interposer 1504 may be formed of an epoxy resin, a fiberglass-reinforced epoxy resin, an epoxy resin with inorganic fillers, a ceramic material, or a polymer material such as polyimide. In some examples, the interposer 1504 may be formed of alternate rigid or flexible materials that may include the same materials described above for use in a semiconductor substrate, such as silicon, germanium, and other group III-V and group IV materials. The interposer 1504 may include metal interconnects 1508 and vias 1510, including but not limited to through-silicon vias (TSVs) 1506. The interposer 1504 may further include embedded devices 1514, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1504. The package-on-interposer structure 1536 may take the form of any of the package-on-interposer structures known in the art.

The IC device assembly 1500 may include an IC package 1524 coupled to the first face 1540 of the circuit board 1502 by coupling components 1522. The coupling components 1522 may take the form of any of the examples discussed above with reference to the coupling components 1516, and the IC package 1524 may take the form of any of the examples discussed above with reference to the IC package 1520.

The IC device assembly 1500 illustrated in FIG. 15 includes a package-on-package structure 1534 coupled to the second face 1542 of the circuit board 1502 by coupling components 1528. The package-on-package structure 1534 may include a first IC package 1526 and a second IC package 1532 coupled together by coupling components 1530 such that the first IC package 1526 is disposed between the circuit board 1502 and the second IC package 1532. The coupling components 1528, 1530 may take the form of any of the examples of the coupling components 1516 discussed above, and the IC packages 1526, 1532 may take the form of any of the examples of the IC package 1520 discussed above. The package-on-package structure 1534 may be configured in accordance with any of the package-on-package structures known in the art.

FIG. 16 is a block diagram of an example electrical device 1600 that may include one or more of the example IC packages 100 of FIG. 1 with any one of the example package substrates disclosed herein constructed in accordance with teachings disclosed herein. For example, any suitable ones of the components of the electrical device 1600 may include one or more of the IC packages 1500, IC devices 1400, or dies 1302 disclosed herein. A number of components are illustrated in FIG. 16 as included in the electrical device 1600, but any one or more of these components may be omitted or duplicated, as suitable for the application. In some examples, some or all of the components included in the electrical device 1600 may be attached to one or more motherboards. In some examples, some or all of these components are fabricated onto a single system-on-a-chip (SoC) die.

Additionally, in various examples, the electrical device 1600 may not include one or more of the components illustrated in FIG. 16, but the electrical device 1600 may include interface circuitry for coupling to the one or more components. For example, the electrical device 1600 may not include a display device 1606, but may include display device interface circuitry (e.g., a connector and driver circuitry) to which a display device 1606 may be coupled. In another set of examples, the electrical device 1600 may not include an audio input device 1624 or an audio output device 1608 but may include audio input or output device interface circuitry (e.g., connectors and supporting circuitry) to which an audio input device 1624 or audio output device 1608 may be coupled.

The electrical device 1600 may include a processing device 1602 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1602 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1600 may include a memory 1604, which may itself include one or more memory devices such as volatile memory (e.g., dynamic random access memory (DRAM)), nonvolatile memory (e.g., read-only memory (ROM)), flash memory, solid state memory, and/or a hard drive. In some examples, the memory 1604 may include memory that shares a die with the processing device 1602. This memory may be used as cache memory and may include embedded dynamic random access memory (eDRAM) or spin transfer torque magnetic random access memory (STT-MRAM).

In some examples, the electrical device 1600 may include a communication chip 1612 (e.g., one or more communication chips). For example, the communication chip 1612 may be configured for managing wireless communications for the transfer of data to and from the electrical device 1600. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some examples they might not.

The communication chip 1612 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1612 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1612 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1612 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1612 may operate in accordance with other wireless protocols in other examples. The electrical device 1600 may include an antenna 1622 to facilitate wireless communications and/or to receive other wireless communications (such as AM or FM radio transmissions).

In some examples, the communication chip 1612 may manage wired communications, such as electrical, optical, or any other suitable communication protocols (e.g., the Ethernet). As noted above, the communication chip 1612 may include multiple communication chips. For instance, a first communication chip 1612 may be dedicated to shorter-range wireless communications such as Wi-Fi or Bluetooth, and a second communication chip 1612 may be dedicated to longer-range wireless communications such as global positioning system (GPS), EDGE, GPRS, CDMA, WiMAX, LTE, EV-DO, or others. In some examples, a first communication chip 1612 may be dedicated to wireless communications, and a second communication chip 1612 may be dedicated to wired communications.

The electrical device 1600 may include battery/power circuitry 1614. The battery/power circuitry 1614 may include one or more energy storage devices (e.g., batteries or capacitors) and/or circuitry for coupling components of the electrical device 1600 to an energy source separate from the electrical device 1600 (e.g., AC line power).

The electrical device 1600 may include a display device 1606 (or corresponding interface circuitry, as discussed above). The display device 1606 may include any visual indicators, such as a heads-up display, a computer monitor, a projector, a touchscreen display, a liquid crystal display (LCD), a light-emitting diode display, or a flat panel display.

The electrical device 1600 may include an audio output device 1608 (or corresponding interface circuitry, as discussed above). The audio output device 1608 may include any device that generates an audible indicator, such as speakers, headsets, or earbuds.

The electrical device 1600 may include an audio input device 1624 (or corresponding interface circuitry, as discussed above). The audio input device 1624 may include any device that generates a signal representative of a sound, such as microphones, microphone arrays, or digital instruments (e.g., instruments having a musical instrument digital interface (MIDI) output).

The electrical device 1600 may include a GPS device 1618 (or corresponding interface circuitry, as discussed above). The GPS device 1618 may be in communication with a satellite-based system and may receive a location of the electrical device 1600, as known in the art.

The electrical device 1600 may include any other output device 1610 (or corresponding interface circuitry, as discussed above). Examples of the other output device 1610 may include an audio codec, a video codec, a printer, a wired or wireless transmitter for providing information to other devices, or an additional storage device.

The electrical device 1600 may include any other input device 1620 (or corresponding interface circuitry, as discussed above). Examples of the other input device 1620 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1600 may have any desired form factor, such as a hand-held or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server or other networked computing component, a printer, a scanner, a monitor, a set-top box, an entertainment control unit, a vehicle control unit, a digital camera, a digital video recorder, or a wearable electrical device. In some examples, the electrical device 1600 may be any other electronic device that processes data.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities and/or steps, the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities and/or steps, the phrase "at least one of A or B" is intended to refer to implementations including any of (1) at least one A, (2) at least one B, or (3) at least one A and at least one B.

As used herein, singular references (e.g., "a," "an," "first," "second," etc.) do not exclude a plurality. The term "a" or "an" object, as used herein, refers to one or more of that object. The terms "a" (or "an"), "one or more," and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

From the foregoing, it will be appreciated that example systems, apparatus, articles of manufacture, and methods have been disclosed that are integrated circuit packages with double hybrid bonded dies. Disclosed systems, apparatus, articles of manufacture, and methods improve the efficiency of using a computing device by increasing the electrical connection between first metal pads of a first die and second metal pads of a second die through at least a second hybrid bond layer between the first metal pads of the first die and the second metal pads of the second die. The increased electrical connection is more efficient, and therefore enables the computing device to execute processor cycles faster. Disclosed systems, apparatus, articles of manufacture, and methods are accordingly directed to one or more improvement(s) in the operation of a machine such as a computer or other electronic and/or mechanical device.

Example methods, apparatus, systems, and articles of manufacture to enable integrated circuit packages with double hybrid bonded dies and methods of manufacturing the same are disclosed herein. Further examples and combinations thereof include the following: Example 1 includes an integrated circuit (IC) package comprising a first semiconductor die including first metal vias spaced apart along a first layer of a first dielectric material, the first metal vias connected to respective first metal pads of the first semiconductor die, the first semiconductor die to include a lateral side, a second semiconductor die including second metal vias spaced apart along a second layer of a second dielectric material, the second metal vias connected to respective second metal pads of the second semiconductor die, and a hybrid bond layer including a third dielectric material and third metal vias spaced apart along the third dielectric material, a subset of the third metal vias electrically coupling ones of the first metal pads to respective ones of the second metal pads, a first one of the third metal vias positioned beyond the lateral side of the first semiconductor die.

Example 2 includes the IC package of example 1, wherein ones of the third metal vias have a first lateral size and ones of the first and second metal vias have a second lateral size, the first lateral size larger than the second lateral size.

Example 3 includes the IC package of example 2, wherein the first metal pads have a third lateral size, the first lateral size being approximately equal to the first lateral size of the third metal vias.

Example 4 includes the IC package of example 1, wherein the hybrid bond layer is a first hybrid bond layer, the IC package further including a second hybrid bond layer that includes a fourth dielectric material and fourth metal vias spaced apart along the fourth dielectric material, ones of the fourth metal vias electrically coupling ones of the third metal vias to respective ones of the second metal vias.

Example 5 includes the IC package of example 4, wherein ones of the subset of the third metal vias are in contact with respective ones of the first metal pads, and ones of the fourth metal vias are in contact with respective ones of the second metal pads.

Example 6 includes the IC package of example 1, wherein ones of subset of the third metal vias extend away from the second layer of the second dielectric material by a first distance, and the first one of the third metal vias extends away from the second layer of the second dielectric material by a second distance, the second distance greater than the first distance.

Example 7 includes the IC package of example 1, wherein the lateral side of the first semiconductor die is a first lateral side, the first semiconductor die includes a second lateral side opposite the first lateral side, and a second one of the third metal vias is positioned between the first and second lateral sides, the second one of the third metal vias electrically isolated from other metal within the first semiconductor die.

Example 8 includes the IC package of example 1, wherein ones of the subset of the third metal vias are a first subset of the third metal vias, the IC package further including a third semiconductor die including fourth metal vias spaced apart along a fourth layer of a fourth dielectric material, the fourth metal vias connected to respective fourth metal pads of the third semiconductor die, a second subset of the third metal vias electrically coupling ones of the fourth metal pads to respective ones of the second metal pads, ones of the first metal pads misaligned with respective ones of the first subset of the third metal vias by a first extent, ones of the fourth metal pads misaligned with respective ones of the second subset of the fourth metal vias by a second extent, the first extent different than the second extent.

Example 9 includes the IC package of example 1, wherein ones of the first metal pads are (a) misaligned with respective ones of the second metal pads by a first extent and (b) misaligned with respective ones of the third metal vias by a second extent, the third metal vias misaligned with respective ones of the second metal pads by a third extent, the second extent smaller than the first extent, the third extent smaller than the first extent.

Example 10 includes the IC package of example 1, wherein a horizontal plane that defines the hybrid bond layer includes a fourth dielectric material different than the third dielectric material, the third metal vias to extend through both the third and fourth dielectric materials.

Example 11 includes the IC package of example 1, wherein ones of the third metal vias are deposited inside ones of the first metal vias.

Example 12 includes an integrated circuit (IC) comprising a first semiconductor die including a first pad layer having a first array of first conductive pads, a second pad layer having a second array of second conductive pads, a third pad layer having a third array of third conductive pads, the second pad layer between the first and third pad layers, ones of the second conductive pads in direct contact with respective ones of the first conductive pads and respective ones of the third conductive pads, and a second semiconductor die including a fourth pad layer having a fourth array of fourth conductive pads, the third pad layer between the second and fourth pad layers, the ones of the third conductive pads in direct contact with respective ones the fourth conductive pads.

Example 13 includes the IC of example 12, wherein a first one of the second conductive pads extends past a lateral side of the first semiconductor die.

Example 14 includes the IC of example 12, wherein the first conductive pads extend through a first dielectric material and the second conductive pads extend through a second dielectric material different than the first dielectric material.

Example 15 includes the IC of example 12, wherein a portion of a second one of the third conductive pads extends into a corresponding one of the first conductive pads.

Example 16 includes the IC of example 12, further including a third semiconductor die, the third semiconductor die including a fifth pad layer having a fifth array of fifth conductive pads, the third semiconductor die positioned laterally adjacent to the first semiconductor die, the second pad layer between (a) the second semiconductor die and (b) both the first and second semiconductor die.

Example 17 includes a method of manufacturing an integrated circuit (IC) package, the method comprising providing first contact pads on a semiconductor substrate, the first contact pads for a first semiconductor die, cutting the semiconductor substrate to define the first semiconductor die, attaching the first semiconductor die to a carrier wafer, the first contact pads to face towards the carrier wafer, attaching a lid to the first and second semiconductor dies, the first and second semiconductor dies to be between the carrier wafer and the lid, attaching a second semiconductor die to a carrier wafer adjacent to the first semiconductor die, removing the carrier wafer from the first and second semiconductor dies, depositing a first hybrid bond pad layer on the first contact pads, the first hybrid bond pad layer including second contact pads, ones of the second contact pads in contact with ones of the first contact pads, and bonding, using wafer-to-wafer bonding, the first hybrid bonding layer to a second hybrid bonding layer on a separate wafer.

Example 18 includes the method of example 17, further including depositing a first dielectric layer on the first contact pads, depositing a testing pad on the first dielectric layer, the testing pad to be electrically coupled to a first one of the first contact pads through the first dielectric layer, testing the semiconductor die using the testing pad, and removing the testing pad to expose the first dielectric layer, the removing of the testing pad to remove portions of the first dielectric layer.

Example 19 includes the method of example 18, wherein the testing pad is larger than a respective one of the first contact pads that underlies the testing pad.

Example 20 includes the method of example 18, further including depositing a second dielectric layer, the second dielectric layer different than the first dielectric layer over the first contact pads, etching openings in the second dielectric layer to generate an indentation, and adding metal into the openings in the second dielectric layer to define the second contact pads.

Example 21 includes the method of example 17, further including, before attaching the lid, depositing a dielectric fill to enclose the first and second semiconductor dies attached to the carrier wafer.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. An integrated circuit (IC) package comprising:
a first semiconductor die including first metal vias spaced apart along a first layer of a first dielectric material, the first metal vias connected to respective first metal pads of the first semiconductor die, the first semiconductor die to include a lateral side;
a second semiconductor die including second metal vias spaced apart along a second layer of a second dielectric material, the second metal vias connected to respective second metal pads of the second semiconductor die; and
a hybrid bond layer including a third dielectric material and third metal vias spaced apart along the third dielectric material, a subset of the third metal vias electrically coupling ones of the first metal pads to respective ones of the second metal pads, a first one of the third metal vias positioned beyond the lateral side of the first semiconductor die.

2. The IC package of claim 1, wherein ones of the third metal vias have a first lateral size and ones of the first and second metal vias have a second lateral size, the first lateral size larger than the second lateral size.

3. The IC package of claim 2, wherein the first metal pads have a third lateral size, the first lateral size being approximately equal to the first lateral size of the third metal vias.

4. The IC package of any one of claims 1-3, wherein the hybrid bond layer is a first hybrid bond layer, the IC package further including a second hybrid bond layer that includes a fourth dielectric material and fourth metal vias spaced apart along the fourth dielectric material, ones of the fourth metal vias electrically coupling ones of the third metal vias to respective ones of the second metal vias.

5. The IC package of claim 4, wherein ones of the subset of the third metal vias are in contact with respective ones of the first metal pads, and ones of the fourth metal vias are in contact with respective ones of the second metal pads.

6. The IC package of any one of claims 1-5, wherein ones of subset of the third metal vias extend away from the second layer of the second dielectric material by a first distance, and the first one of the third metal vias extends away from the second layer of the second dielectric material by a second distance, the second distance greater than the first distance.

7. The IC package of any one of claims 1-6, wherein the lateral side of the first semiconductor die is a first lateral side, the first semiconductor die includes a second lateral side opposite the first lateral side, and a second one of the third metal vias is positioned between the first and second lateral sides, the second one of the third metal vias electrically isolated from other metal within the first semiconductor die.

8. The IC package of any one of claims 1-7, wherein ones of the subset of the third metal vias are a first subset of the third metal vias, the IC package further including a third semiconductor die including fourth metal vias spaced apart along a fourth layer of a fourth dielectric material, the fourth metal vias connected to respective fourth metal pads of the third semiconductor die, a second subset of the third metal vias electrically coupling ones of the fourth metal pads to respective ones of the second metal pads, ones of the first metal pads misaligned with respective ones of the first subset of the third metal vias by a first extent, ones of the fourth metal pads misaligned with respective ones of the second subset of the fourth metal vias by a second extent, the first extent different than the second extent.

9. The IC package of any one of claims 1-8, wherein ones of the first metal pads are (a) misaligned with respective ones of the second metal pads by a first extent and (b) misaligned with respective ones of the third metal vias by a second extent, the third metal vias misaligned with respective ones of the second metal pads by a third extent, the second extent smaller than the first extent, the third extent smaller than the first extent.

10. The IC package of any one of claims 1-9, wherein a horizontal plane that defines the hybrid bond layer includes a fourth dielectric material different than the third dielectric material, the third metal vias to extend through both the third and fourth dielectric materials.

11. The IC package of any one of claims 1-10, wherein ones of the third metal vias are deposited inside ones of the first metal vias.

12. A method of manufacturing an integrated circuit (IC) package, the method comprising:
providing first contact pads on a semiconductor substrate, the first contact pads for a first semiconductor die;
cutting the semiconductor substrate to define the first semiconductor die;
attaching the first semiconductor die to a carrier wafer, the first contact pads to face towards the carrier wafer;
attaching a lid to the first and second semiconductor dies, the first and second semiconductor dies to be between the carrier wafer and the lid;
attaching a second semiconductor die to a carrier wafer adjacent to the first semiconductor die;
removing the carrier wafer from the first and second semiconductor dies;
depositing a first hybrid bond pad layer on the first contact pads, the first hybrid bond pad layer including second contact pads, ones of the second contact pads in contact with ones of the first contact pads; and
bonding, using wafer-to-wafer bonding, the first hybrid bonding layer to a second hybrid bonding layer on a separate wafer.

13. The method of claim 12, further including:
depositing a first dielectric layer on the first contact pads;
depositing a testing pad on the first dielectric layer, the testing pad to be electrically coupled to a first one of the first contact pads through the first dielectric layer;
testing the semiconductor die using the testing pad; and
removing the testing pad to expose the first dielectric layer, the removing of the testing pad to remove portions of the first dielectric layer.

14. The method of claim 13, wherein the testing pad is larger than a respective one of the first contact pads that underlies the testing pad.

15. The method of any one of claims 13-14, further including:
depositing a second dielectric layer, the second dielectric layer different than the first dielectric layer over the first contact pads;
etching openings in the second dielectric layer to generate an indentation; and
adding metal into the openings in the second dielectric layer to define the second contact pads.
